# EUROPEAN PATENT APPLICATION

(11) **EP 4 832 048 A1**
(43) Date of publication of application: **28.10.2026**
(21) Application number: 25172684.0
(22) Date of filing: 25.04.2025
(51) Int. Cl.: H01L 21/265, H01L 21/425, H01L 21/285, H01L 21/441, H10D 62/832, H10D 62/85, H10D 62/80

(54) **METHOD FOR GENERATING A METAL-SEMICONDUCTOR CONTACT, AND SEMICONDUCTOR DEVICE**

(71) Applicant: Hitachi Energy Ltd, 8050 Zürich (CH)
(72) Inventor: ALFIERI, Giovanni, 5103 Möriken (CH); BOLAT, Sami, 5630 Muri (CH); POCATERRA, Marco Pietro Marcello, 5603 Staufen (CH)
(74) Representative: Michalski Hüttermann & Partner mbB

(57) **Abstract**

The invention relates to a method for generating a metal-semiconductor contact in a semiconductor device (20) comprising the steps of
- providing a structure (10), wherein the structure (10) comprises a substrate (12) with a top surface formed by a semiconductor layer (14), the semiconductor layer (14) preferably being of a first conductivity type,
- generating an implanted region (16) preferably of a second conductivity type within the semiconductor layer (14) by ion implantation, such that the semiconductor layer (14) forms a superficial layer (14') adjacent to the implanted region (16),
- annealing the structure (10) with the implanted region (16), and
- treating the annealed structure (10) such that the implanted region (16) forms the top surface.

Furthermore, the invention relates to a semiconductor device (20) comprising a metal-semiconductor contact obtained by the above method.

Additionally, the invention relates to a semiconductor device (20) comprising a substrate (12), a semiconductor layer (14) formed on the substrate (12), and an implanted region (16) formed on the semiconductor layer (14), wherein the top surface of the semiconductor device (20) is formed by the implanted region (16) and wherein the top surface comprises a surface roughness Rq of not more than 10 nm.

## Description

### Technical Field

The invention relates to a method for generating a metal-semiconductor contact in a semiconductor device.

Furthermore, the invention relates to a semiconductor device comprising a metal-semiconductor contact obtained by the above method.

Additionally, the invention relates to a semiconductor device comprising a substrate, a semiconductor layer formed on the substrate, and an implanted region formed on the semiconductor layer, the semiconductor layer preferably being of a first conductivity type, and the implanted region preferably being of a second conductivity type, wherein the top surface of the semiconductor device is formed by the implanted region.

### Background Art

Power semiconductor devices are used as switches controlling the current flow through various electronic systems. Many power semiconductor devices make use of a metal-oxide-semiconductor (MOS) structure. Devices that comprise a MOS structure are for example a power MOS field-effect transistor (MOSFET) designed to handle significant power levels or an insulated-gate bipolar transistor (IGBT).

While silicon (Si) is a very common semiconductor material for power semiconductor devices, power semiconductor devices formed with wide-bandgap semiconductor materials as substrate such as a silicon carbide substrate (SiC substrate) composed of silicon (Si) and carbon (C) bonded to each other at a composition ratio of 1:1 are becoming more and more important.

For example, SiC offers a number of attractive characteristics for high-voltage power semiconductors when compared to commonly used Si. Exemplarily the much higher breakdown field strength and a high thermal conductivity of SiC in principle allow creating devices which outperform by far the corresponding Si devices and enable reaching otherwise unattainable efficiency levels. SiC based power MOSFETs may offer superior dynamic performance over conventional Si based power MOSFETs.

The metal-semiconductor contact is an important component in the performance of most semiconductor devices. There are basically two types of metal-semiconductor contacts that are widely used in semiconductor devices, i.e. Schottky contacts and Ohmic contact. In SiC devices these contacts are generally formed by high dose of Aluminium implantation, followed by annealing at high temperature. This has however the disadvantage that due to the high temperature the Silicon from the SiC outgases which leads to a high surface roughness of the device. To overcome this problem, it is known to protect the surface by a capping during the annealing process. This can be achieved by applying a photoresist to the SiC surface followed by a soft baking step at low temperature (around 200 °C) and a hard baking step at high temperature (around 700 °C to 900 °C).

However, despite the capping, the SiC surface still has a high surface roughness after annealing compared to the as-grown epilayer, as the capping is not completely adherent to the SiC surface, leaves some regions unprotected and/or deteriorates during annealing. A high surface roughness however negatively affects the electrical properties of the semiconductor device.

Thus, there is a need to decrease the surface roughness, increase the electrical performance of the semiconductor device and/or simplify the process of generating metal-semiconductor contacts.

### Summary of invention

It is an object of the invention to provide means to improve the performance of power semiconductor devices. Furthermore, it is an object of decrease the surface roughness and/or simplify the process of generating metal-semiconductor contacts. The object of the invention is solved by the features of the independent claims. Modified embodiments are detailed in the dependent claims.

Thus, the object is solved by a method for generating a metal-semiconductor contact in a semiconductor device comprising the steps of
- providing a structure, wherein the structure comprises a substrate with a top surface formed by a semiconductor layer, the semiconductor layer preferably being of a first conductivity type,
- generating an implanted region preferably of a second conductivity type within the semiconductor layer by ion implantation, such that the semiconductor layer forms a superficial layer adjacent to the implanted region,
- annealing the structure with the implanted region, and
- treating the annealed structure such that the implanted region forms the top surface.

Furthermore, the object is also solved by a semiconductor device comprising a metal-semiconductor contact obtained by the above method.

Additionally, the object is solved by a semiconductor device comprising a substrate, a semiconductor layer formed on the substrate, and an implanted region formed on the semiconductor layer, the semiconductor layer preferably being of a first conductivity type, and the implanted region preferably being of a second conductivity type, wherein the top surface of the semiconductor device is formed by the implanted region and
a) wherein the top surface comprises a surface roughness Rq of not more than 10 nm and/or
b) the semiconductor device has a carbon vacancies concentration in an implant tail region of the implanted region of less than 1×10¹² cm⁻³.

One aspect of the invention is that in the method for generating the metal-semiconductor contact, no additional capping is used. Instead, the implanted region is generated within the semiconductor layer, allowing the superficial semiconductor layer to act as protection layer in the following annealing step. Formulated in other words, the semiconductor layer itself is used as capping in the annealing step. Because the superficial semiconductor layer has a high surface roughness after the annealing step, the annealed structure is treated such that the implanted region forms the top surface. Thereby a smooth top surface is achieved.

This has not only the advantage that the electrical properties of the semiconductor device are increased, such as a lower on resistance R_{ON} and in turn a higher drain source current I_{DS}, but has also the advantage that the manufacturing process is greatly simplified. In particular, there is no need, as in the prior art with the photoresist layer, to use an extra processing step for formation of the capping.

According to a preferred embodiment of the invention the semiconductor layer of the provided structure has a thickness of 1 µm to 200 µm. As starting point, preferably the structure with the semiconductor layer with a thickness of up to 200 µm is used. This allows to easily form the implanted region within the semiconductor layer.

As already mentioned, the semiconductor layer is of the first conductivity type, while the implanted region is of the second conductivity type. In connection with this it is preferred that the semiconductor layer of the provided structure is of n-type. Additionally or alternatively it is further preferred that the implanted region is of p+type. Further preferably, the implanted region is generated by implantation of aluminium ions.

In connection to the semiconductor layer and according to a preferred embodiment of the invention, the semiconductor layer of the provided structure is a wide-bandgap semiconductor layer, and preferably a silicon carbide layer, a gallium nitride layer, or a gallium(III) oxide layer. The method can be used with different materials, wherein silicon carbide is preferred. For silicon carbide and gallium nitride, the implanted region is preferably of p+type. For gallium(III) oxide, the implanted region is preferably of n+type.

A wide-bandgap semiconductor is a semiconductor having a bandgap greater than the bandgap of silicon. Preferably, the bandgap of the semiconductor layer is greater than 1.5 eV and further preferably greater 2 eV. Regarding the material of the wide-bandgap semiconductor layer and according to a preferred embodiment of the invention, the wide-bandgap semiconductor layer is preferably a silicon carbide layer (SiC layer), a gallium nitride layer, or a gallium(III) oxide layer. Preferably, the wide-bandgap semiconductor layer is a silicon carbide layer or a gallium nitride layer, and further preferably the wide-bandgap semiconductor layer is a silicon carbide layer.

According to another preferred embodiment of the invention the semiconductor layer of the provided structure is a silicon carbide layer and a) of 4H-SiC polytype, b) a {0001} oriented layer, and/or c) a homoepitaxially grown epilayer, and preferably a homoepitaxially grown n-type 4H-SiC epilayer. 4H-SiC is the preferred polytype for silicon carbide semiconductor devices, such as SiC power MOSFETs, due to the advances in 4H-SiC growth technology as well as its attractive electronic properties such as larger band gap and higher carrier mobility over other polytypes, such as 6H-SiC or 3C-SiC. Alternatively or additionally the silicon carbide layer is a {0001} oriented layer. Particularly preferred, the silicon carbide layer is a {0001} oriented 4H-SiC layer epitaxially grown on a {0001} oriented 4H-SiC substrate.

According to a preferred embodiment of the invention the implanted region is generated within the semiconductor layer at least 50 nm away from the top surface, and preferably 50 nm to 100 nm away from the top surface. In other words, instead of creating the implanted region on the surface of the semiconductor layer, it is generated deeper within the semiconductor layer. Thus, the superficial semiconductor layer acting as protection is preferably at least 50 nm thick, and further preferably 50 nm to 100 nm thick.

In connection to this and according to a further preferred embodiment of the invention, the implanted region is generated by ion implantation with ion beam energies of at least 60 keV, preferably at least 100 keV, and even more preferably at least 120 keV. Thus, instead of using low beam energies to create the implanted region at the surface, high beam energies are used for an implantation deep within the semiconductor layer. Further preferably the implanted region is generated by a high-dose box-profile, preferably with multiple energies ion implantation.

Ion implantation is a process by which ions of the desired element - preferably Aluminium ions - are accelerated into a solid target - i.e. the semiconductor layer. Ion implantation is preferably performed with an ion source, where the ions are produced, an accelerator, where the ions are accelerated, and a target chamber, where the ions impinge on semiconductor layer.

According to another preferred embodiment of the invention, the implanted region is generated by ion implantation with ion doses of at least 1x10²⁰ cm⁻². It was found that such ion doses are appropriate to generate the implanted region, in particular for a p+type implanted region.

In connection with ion implantation and according to another preferred embodiment of the invention, the step of generating an implanted region of a second conductivity type within the semiconductor layer by ion implantation comprises generating aluminium ions with an ion source. Particularly preferably the aluminum ions are accelerated to the required ion beam energies and separated by a magnetic field. Further preferably, only ions with a specific value of the product of mass and velocity/charge are used for implantation into the semiconductor layer.

After having generated the implanted region, the structure with the implanted region is annealed. In connection to this and according to a preferred embodiment of the invention, annealing the structure with the implanted region is carried out at least at 1600 °C, preferably at least at 1650 °C, and further preferably at least at 1700 °C. The superficial semiconductor layer protects as capping the implanted region during annealing.

After annealing, the superficial semiconductor layer comprises a high surface roughness due to outgassing of Silicon. In connection to this and according to another preferred embodiment of the invention, treating the annealed structure such that the implanted region forms the top surface is achieved by removing the superficial layer. In other words, as the high surface roughness of the superficial semiconductor layer makes it unsuitable for the metal-semiconductor contact, it is preferably removed, such that after removal the implanted region forms the top surface.

In connection to this and according to another preferred embedment of the invention, removing the superficial layer comprises generating an oxidized superficial layer by oxidation and removing the oxidized superficial layer by wet etching. Preferably oxidation inject carbon interstitials into the semiconductor layer, leading to the presence of carbon interstitials in the implanted region as well as in further regions of the semiconductor layer. After oxidization, the oxidized layer is preferably removed by wet etching with HF, leaving a non-rough top surface formed by the implanted region.

Oxidation temperature and time is preferably determined according to the thickness of the superficial semiconductor layer. In connection to this and in a preferred embodiment oxidation is performed by treating the superficial layer in an oxygen atmosphere at 1100 °C to 1300 °C.

Alternatively to removing the superficial semiconductor layer that comprises a high surface roughness after annealing as described above, and according to another preferred embodiment of the invention, treating the annealed structure such that the implanted region forms the top surface is achieved by treating the superficial layer with plasma immersion ion implantation. Preferably, this leads to the formation of a thicker implanted region having a low surface roughness.

Plasma-immersion ion implantation is a surface modification technique of extracting accelerated ions from a plasma by applying a high voltage pulsed direct current or pure direct current power supply and targeting the ions into the superficial semiconductor layer in order to implant the ions within the superficial semiconductor layer.

Preferably a plasma is generated in vacuum chamber with a plasma source such as an electron cyclotron resonance plasma source, a helicon plasma source, a capacitively coupled plasma source, or an inductively coupled plasma source. The vacuum chamber can be of the diode type or the triode type depending upon whether a power supply is applied to the structure comprising the superficial semiconductor layer, or to a perforated grid.

Further characteristics and advantages of the method for generating a metal-semiconductor contact are evident to the skilled person by the following description of the semiconductor device and the further description of the specific embodiments.

As already mentioned, the invention is also directed to the semiconductor device comprising a metal-semiconductor contact obtained by the above-described method. Due to the low surface roughness, the semiconductor device has a lower on resistance R_{ON} and higher drain source current I_{DS}. Additionally due to the simplified manufacturing process of the semiconductor device is less expensive.

As also already mentioned, the the invention is also directed to the semiconductor device comprising the substrate, the semiconductor layer formed on the substrate, and the implanted region formed on the semiconductor layer, the semiconductor layer being preferably of a first conductivity type, and the implanted region being preferably of a second conductivity type, wherein the top surface of the semiconductor device is formed by the implanted region and
a) wherein the top surface comprises a surface roughness Rq of not more than 10 nm and/or
b) the structure has a carbon vacancies Vc concentration in an implant tail region of the implanted region of less than 1×10¹² cm⁻³.

Preferably the surface roughness Rq relates to the root mean square average of the profile height deviations from the mean line and is preferably determined by atomic force microscopy (AFM). Further preferably Rq is determined according to DIN EN ISO 21920 standard. Further preferably the surface roughness Rq is lower than 10 nm, more preferably lower than 7 nm and even more preferably lower than 5 nm.

Further preferably the carbon vacancies concentration in the implant tail region of the implanted region is less than 1×10¹¹ cm⁻³, and even more preferably less than 1×10¹⁰ cm⁻³. Due to the generation of the metal-semiconductor contact in a semiconductor device, carbon vacancies can be avoided. It is believed that the carbon vacancies that have been created by the generation of the implanted region by ion implantation are removed from the implant tail region in the step of treating the annealed structure such that the implanted region forms the top surface. In particular it is believed that oxidation leads to the formation of carbon interstitials in the implanted region such that carbon vacancies are removed in the implant tail region.

The carbon vacancies concentration is preferably determined by deep level transient spectroscopy (DLTS). DLTS is an experimental tool for studying electrically active defects and measure their concentration in the material. Preferably conventional DLTS, and/or constant-capacitance DLTS is used.

According to another preferred embodiment of the invention, the semiconductor device comprises carbon clusters in the implanted region. Preferably, the concentration of the carbon clusters in the implanted region is more than 1×10¹² cm⁻³, or more than 1×10¹¹ cm⁻³, or more than 1×10¹⁰ cm⁻³. The presence of carbon clusters is preferably determined by Raman spectroscopy.

Preferably the semiconductor device is manufactured using the method for generating the metal-semiconductor contact in a semiconductor device. Further preferably the semiconductor device is a power semiconductor device. Further preferably the power semiconductor device is a 1.2 kV to 6.5 kV volt class power semiconductor device. Further preferably the power semiconductor device is configured for current ratings of 5 A to 600 A in a temperature range of 25 °C to 175 °C.

According to another preferred embodiment of the invention, the semiconductor device is a silicon carbide semiconductor device. In other words, preferably a semiconductor device is provided wherein the wide-bandgap semiconductor layer is a silicon carbide layer.

According to another preferred embodiment of the invention the semiconductor device is preferably a Schottky diode, an insulated-gate bipolar transistor (IGBT), a metal oxide semiconductor field effect transistor (MOSFET), in particular a power MOSFET, a gate turn-off thyristor (GTO), an integrated gate-commutated thyristor (IGCT), or a bipolar junction transistor (BJT).

These and other aspects of the invention will be apparent from and elucidated with reference to the embodiments described hereinafter.

In the drawings:
- Fig. 1: schematically shows the steps of a method for generating a metal-semiconductor contact in a semiconductor device according to a preferred embodiment of the invention, and
- Fig. 2: schematically shows results of a simulation of a MOSFET structure simulating a MOSFET according to a preferred embodiment of the invention, and the simulated current-voltage I_{DS}-V_{DS} characteristics.

### Description of embodiments

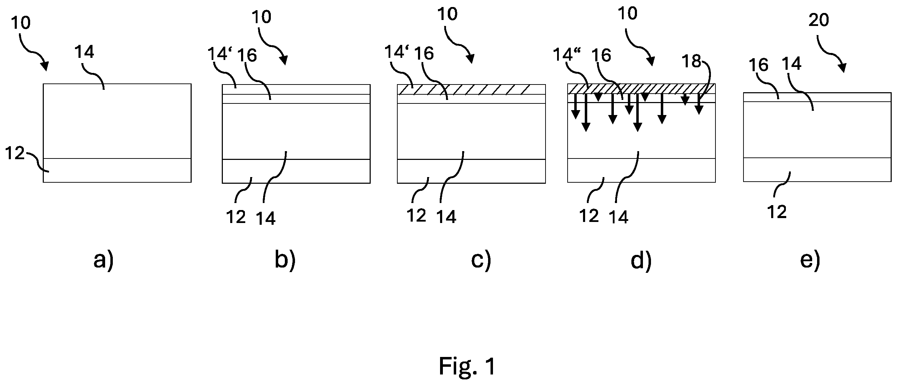

Figure 1 schematically shows the steps of a method for generating a metal-semiconductor contact in a semiconductor device. In a first step of the method, shown in figure 1a) a structure 10 is provided. The structure 10 comprises a substrate 12 with a top surface formed by a semiconductor layer 14. In this preferred embodiment the structure 10 shown in Figure 1a) is formed by epitaxially growing a {0001} oriented 4H-SiC layer 14 on a {0001} oriented 4H-SiC n-type substrate 12. The semiconductor layer 14 is around 100 µm thick.

In a second step of the method, shown in figure 1b) an implanted region 16 is generated within the semiconductor layer 14 by ion implantation, such that the semiconductor layer 14 forms a superficial layer 14' adjacent to the implanted region 16. In this embodiment the implanted ions are Aluminum ions, such that the implanted region 16 forms a p+region. For ion implantation a high-dose box-profile is used with ion beam energies of at least 100 keV. Hence, the implanted region 16 is formed about 70 nm away from the surface of the structure 10.

Subsequently to the second step and as shown in figure 1c), the structure 10 with the implanted region 16 is annealed. This is carried out at around 1700 °C. After annealing the superficial layer 14' has a high surface roughness due to outgassing of Silicon.

In the next step shown in figure 1d) an oxidized superficial layer 14" is generated by oxidation of the superficial layer 14'. The oxidation injects carbon interstitials, as indicated by the arrows 18 in figure 1d) into the semiconductor layer 14 and the implanted region 16. Oxidation is carried out in an oxygen atmosphere at around 1200 °C.

After oxidation the oxidized superficial layer 14" is removed by wet etching as shown in figure 1e). Thus, the implanted region 16 forms the top surface.

Hence, with this method a semiconductor device 20 comprising the substrate 12, the semiconductor layer 14 formed on the substrate, and the implanted region 16 formed on the semiconductor layer 14 is obtained. The top surface of the semiconductor device 20 is formed by the implanted region 16 and comprises a surface roughness Rq of 2 nm.

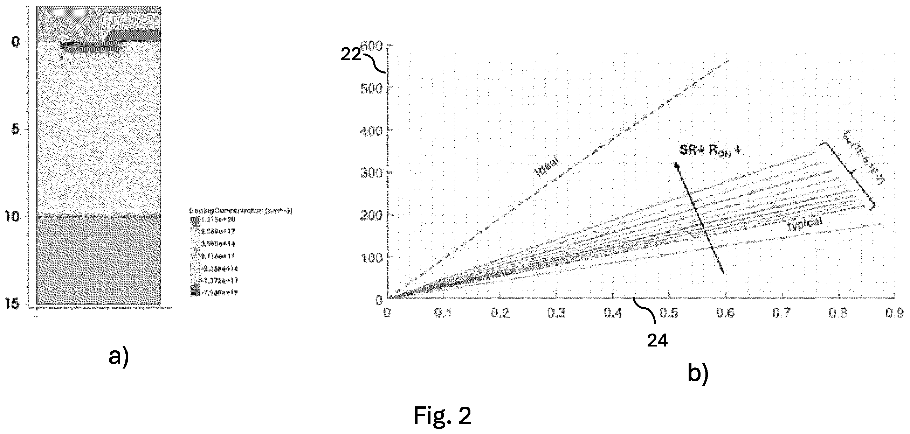

Figure 2 schematically shows results of a simulation of a MOSFET structure simulating a MOSFET according to a preferred embodiment of the invention, and the simulated current-voltage I_{DS}-V_{DS} characteristics.

The simulations were carried out for a SiC MOSFET as shown in Figure 2a). The results shown in Table 1 below as well as the simulated current-voltage I_{DS}-V_{DS} characteristics in figure 2b) show, that the less the surface roughness the better the electronic properties of a device. A lower surface roughness corresponds to a lower R_{ON}. In turn, the improvement of R_{ON} leads to a higher I_{DS} as illustrated in the diagram in Figure 2b). The diagram depicts the drain to source current I_{DS} in A/cm² on the y-axis 22 and the drain to source voltage V_{DS} in V on the x-axis 24.

| Tabel 1 | |
|---|---|
| I_{crit} ∝ surface roughness [cm] | R_{ON,SP} |
| ideal | 1.77 |
| 10⁻¹⁰ | 1.83 |
| 10⁻⁹ | 1.83 |
| 10⁻⁸ | 1.85 |
| 10⁻⁷ | 2.90 |
| 10⁻⁶ (Typical) | 4.55 |
| 10⁻⁵ | 5.57 |

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosed, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 10: structure
- 12: substrate
- 14: semiconductor layer
- 14': superficial layer
- 14": oxidized superficial layer
- 16: implanted region
- 18: arrow
- 20: semiconductor device
- 22: y-axis in figure 2b, drain to source current I_{DS} in A/cm²
- 24: x-axis in figure 2b, drain to source voltage V_{DS} in V

## Claims

1. Method for generating a metal-semiconductor contact in a semiconductor device (20) comprising the steps of
- providing a structure (10), wherein the structure (10) comprises a substrate (12) with a top surface formed by a semiconductor layer (14), the semiconductor layer (14) preferably being of a first conductivity type,
- generating an implanted region (16) preferably of a second conductivity type within the semiconductor layer (14) by ion implantation, such that the semiconductor layer (14) forms a superficial layer (14') adjacent to the implanted region (16),
- annealing the structure (10) with the implanted region (16), and
- treating the annealed structure (10) such that the implanted region (16) forms the top surface.

2. Method according to the previous claim, wherein the semiconductor layer (14) of the provided structure (10) has a thickness of 1 µm to 200 µm.

3. Method according to any of the previous claims, wherein the semiconductor layer (14) of the provided structure (10) is of n-type and/or wherein the implanted region (16) is of p+type.

4. Method according to any of the previous claims, wherein the semiconductor layer (14) of the provided structure (10) is a wide-bandgap semiconductor layer, and preferably a silicon carbide layer, a gallium nitride layer, or a gallium(III) oxide layer.

5. Method according to any of the previous claims, wherein the semiconductor layer (14) of the provided structure (10) is a silicon carbide layer and a) of 4H-SiC polytype, b) a {0001} oriented layer, and/or c) a homoepitaxially grown epilayer, and preferably a homoepitaxially grown n-type 4H-SiC epilayer.

6. Method according to any of the previous claims, wherein the implanted region (16) is generated within the semiconductor layer (14) at least 50 nm away from the top surface, and preferably 50 nm to 100 nm away from the top surface.

7. Method according to any of the previous claims, wherein the implanted region (16) is generated by ion implantation with ion beam energies of at least 60 keV, preferably at least 100 keV, and more preferably at least 120 keV.

8. Method according to any of the previous claims, wherein the implanted region (16) is generated by ion implantation with ion doses of at least 1x10²⁰ cm⁻².

9. Method according to any of the previous claims, wherein annealing the structure (10) with the implanted region (16) is carried out at least at 1600 °C, preferably at least at 1650 °C, and more preferably at least at 1700 °C.

10. Method according to any of the previous claims, wherein treating the annealed structure (10) such that the implanted region (16) forms the top surface is achieved by removing the superficial layer (14').

11. Method according to the previous claim, wherein removing the superficial layer (14') comprises generating an oxidized superficial layer (14") by oxidation and removing the oxidized superficial layer (14") by wet etching.

12. Method according to the previous claim, wherein oxidation is performed by treating the superficial layer (14') in an oxygen atmosphere at 1100 °C to 1300 °C.

13. Method according to any of claims 1 to 9, wherein treating the annealed structure (10) such that the implanted region (16) forms the top surface is achieved by treating the superficial layer (14') with plasma immersion ion implantation.

14. Semiconductor device (20) comprising a metal-semiconductor contact obtained by the method according to any of the preceding claims.

15. Semiconductor device (20) comprising a substrate (12), a semiconductor layer (14) formed on the substrate (12), and an implanted region (16) formed on the semiconductor layer (14), the semiconductor layer (14) preferably being of a first conductivity type, and the implanted region (16) preferably being of a second conductivity type, wherein the top surface of the semiconductor device (20) is formed by the implanted region (16) and
a) wherein the top surface comprises a surface roughness Rq of not more than 10 nm, preferably not more than 7 nm, and even mor preferably not more than 5 nm; and/or
b) wherein the semiconductor device (20) has a carbon vacancies concentration in an implant tail region of the implanted region (16) of less than 1×10¹² cm⁻³, preferably less than 1×10¹¹ cm⁻³, and even more preferably less than 1×10¹⁰ cm⁻³.

16. Semiconductor device (20) according to the previous claim, wherein the semiconductor device (20) comprises carbon clusters in the implanted region (16).

## Amended claims

### Amended claims in accordance with Rule 137(2) EPC.

1. Method for generating a metal-semiconductor contact in a semiconductor device (20) comprising the steps of
- providing a structure (10), wherein the structure (10) comprises a substrate (12) with a top surface formed by a semiconductor layer (14), the semiconductor layer (14) preferably being of a first conductivity type,
- generating an implanted region (16) preferably of a second conductivity type within the semiconductor layer (14) by ion implantation, such that the semiconductor layer (14) forms a superficial layer (14') adjacent to the implanted region (16),
- annealing the structure (10) with the implanted region (16), and
- treating the annealed structure (10) such that the implanted region (16) forms the top surface,
**characterized in that** the implanted region (16) is generated by ion implantation with ion doses of at least 1x10²⁰ cm⁻².

2. Method according to the previous claim, wherein the semiconductor layer (14) of the provided structure (10) has a thickness of 1 µm to 200 µm.

3. Method according to any of the previous claims, wherein the semiconductor layer (14) of the provided structure (10) is of n-type and/or wherein the implanted region (16) is of p+type.

4. Method according to any of the previous claims, wherein the semiconductor layer (14) of the provided structure (10) is a wide-bandgap semiconductor layer, and preferably a silicon carbide layer, a gallium nitride layer, or a gallium(III) oxide layer.

5. Method according to any of the previous claims, wherein the semiconductor layer (14) of the provided structure (10) is a silicon carbide layer and a) of 4H-SiC polytype, b) a {0001} oriented layer, and/or c) a homoepitaxially grown epilayer, and preferably a homoepitaxially grown n-type 4H-SiC epilayer.

6. Method according to any of the previous claims, wherein the implanted region (16) is generated within the semiconductor layer (14) at least 50 nm away from the top surface, and preferably 50 nm to 100 nm away from the top surface.

7. Method according to any of the previous claims, wherein the implanted region (16) is generated by ion implantation with ion beam energies of at least 60 keV, preferably at least 100 keV, and more preferably at least 120 keV.

8. Method according to any of the previous claims, wherein annealing the structure (10) with the implanted region (16) is carried out at least at 1600 °C, preferably at least at 1650 °C, and more preferably at least at 1700 °C.

9. Method according to any of the previous claims, wherein treating the annealed structure (10) such that the implanted region (16) forms the top surface is achieved by removing the superficial layer (14').

10. Method according to the previous claim, wherein removing the superficial layer (14') comprises generating an oxidized superficial layer (14") by oxidation and removing the oxidized superficial layer (14") by wet etching.

11. Method according to the previous claim, wherein oxidation is performed by treating the superficial layer (14') in an oxygen atmosphere at 1100 °C to 1300 °C.

12. Method according to any of claims 1 to 8, wherein treating the annealed structure (10) such that the implanted region (16) forms the top surface is achieved by treating the superficial layer (14') with plasma immersion ion implantation.
